# FASCICULE DE BREVET EUROPEEN

(11) **EP 3 635 833 B1**
(45) Date de publication et mention de la délivrance du brevet: **29.05.2024**
(21) Numéro de dépôt: 18736993.9
(22) Date de dépôt: 07.06.2018
(51) Int. Cl.: H02H 3/33

(54) **DISPOSITIF DE PROTECTION DIFFERENTIELLE POUR LA DETECTION D'UN COURANT DE DEFAUT**
DIFFERENZIALSCHUTZVORRICHTUNG ZUR DETEKTION EINES FEHLERSTROMS
DIFFERENTIAL PROTECTION DEVICE FOR DETECTING A FAULT CURRENT

(30) Priorité: 08.06.2017 FR 1755133
(43) Date de publication de la demande: 15.04.2020
(73) Titulaire: Hager-Electro SAS, 67210 Obernai (FR)
(72) Inventeur: JOYEUX, Patrice, 67140 Heiligenstein (FR); DOLISY, Bastien, 67210 OBERNAI (FR)
(74) Mandataire: Cabinet Nuss
(86) Numéro de dépôt international: PCT/FR2018/051324
(87) Numéro de publication internationale: WO 2018/224784

(56) Documents cités:
- WO-A2-2017/072442
- DE-A1-102011 011 983
- US-B1- 6 747 856

## Description

La présente invention concerne les équipements et systèmes de sécurité des biens et des personnes dans le domaine électrique, plus particulièrement les dispositifs de protection de personnes à courant différentiel résiduel (ou DDR), et a pour objet un dispositif de protection différentiel intégrant une fonction coupe-feu.

Ce type de dispositif de protection est couramment intégré dans des installations électriques domestiques ou tertiaires, en amont ou à l'entrée des diverses arborescences des circuits d'alimentation en place, voir au plus près des récepteurs auxquels ils sont respectivement affectés.

Typiquement, ces installations électriques sont alimentées par un réseau électrique alternatif, et des dispositifs de protection du type précité ont pour but d'assurer principalement la sécurité des personnes en détectant le plus rapidement possible toute fuite éventuelle vers la terre dans un des circuits ou récepteurs à protéger. De telles fuites sont par exemple causées par des contacts directs de sujets avec un conducteur non isolé ou des contacts indirects dus à des défauts de masse. Ces incidents électriques sont susceptibles de générer des accidents, parfois mortels, des détériorations de matériel(s), des départs d'incendie, des dysfonctionnements localisés ou généralisés ou analogues.

La protection différentielle, dans le contexte précité, s'effectue dans la plupart des cas d'une manière assez standardisée : au moins l'un des ou tous les conducteurs du circuit à protéger, ou l'un des ou les conducteurs de la ligne d'alimentation de ce circuit, passe(nt) dans un tore de matériau ferromagnétique d'un transformateur dont le(s) conducteur(s) précité(s) forme(nt) le primaire et qui comporte un ou plusieurs enroulement(s) ou bobinage(s) secondaire(s). Le tore joue le rôle d'un concentrateur de flux magnétique. Ainsi en cas de fuite, se traduisant par un déséquilibre des courants d'entrée et de sortie dans les conducteurs des lignes à protéger, le flux créé dans le tore par ce déséquilibre au niveau du primaire, induit dans le bobinage secondaire une tension, utilisée pour commander directement, ou à travers une électronique dédiée (étages de traitement des signaux), un actionneur (par exemple de type relais). Ce dernier actionne à son tour un mécanisme de déclenchement, de coupure ou d'ouverture associé, ou ceux d'autres appareils de protection de l'installation.

Ces appareils ou dispositifs électriques de protection différentielle peuvent présenter des caractéristiques variables. Ainsi, ils sont mutuellement différentiables et caractérisés par leur sensibilité propre, qui dépend notamment du type d'installation électrique dans laquelle ils sont utilisés et qu'ils sont destinés à protéger. Par ailleurs, certains de ces appareils ne sont capables de détecter des fuites que pour des courants alternatifs (type AC) alors que d'autres, plus complets, offrent des solutions également applicables au courant continu pulsé (types A et F) ou lissé (type B).

Un dispositif du type B est par exemple décrit dans la demande de brevet français n° 2 993 058 au nom de la demanderesse.

Par ailleurs, pour les dispositifs ayant la capacité de détecter des courants de défaut alternatifs, la fréquence limite supérieure de détection constitue un autre critère de distinction entre les différents types : fréquences jusqu'à 1kHz : type F ; fréquences jusqu'à 2kHz : type B ; fréquences jusqu'à 20kHz : type B+.

En particulier, le type B+ est, par rapport aux autres types, spécifiquement sensible aux fréquences de courant de défaut ou de fuite propices aux départs de feu.

Actuellement, les solutions existantes pour atteindre le gabarit fréquentiel requis pour un classement de type B+ sont principalement de deux types :
- mise en oeuvre d'un ensemble électronique actif réalisant des corrections adaptées de la bande passante de la courbe de sensibilité à la fréquence du courant de défaut. Un défaut d'alimentation de l'ensemble électronique transforme ce dispositif de type B+ en un dispositif de type A/AC seulement (les fonctionnalités liées au type F ou au type B ne sont plus remplies).
- mise en oeuvre d'un relais électronique pour inhiber la protection de type A/AC et son remplacement par un moyen actif réalisant la fonction AC, A, F et B.

Dans les deux solutions précitées du type B+, on aboutit à une construction complexe, coûteuse et encombrante fondée sur la mise en oeuvre de deux circuits indépendants en parallèle ou en concurrence, la fonction coupe-feu étant inopérante en cas d'absence d'alimentation secteur.

Par le document EP 1 201 015, on connaît un dispositif de protection contre les courants de défaut avec un transformateur de courant cumulé et un circuit de déclenchement relié à un enroulement secondaire dudit transformateur. Ce circuit de déclenchement comprend un montage de déclenchement avec un circuit RC relié en parallèle sur son entrée connectée à l'enroulement secondaire. Ce circuit RC est dimensionné de telle manière que la valeur du courant de défaut de déclenchement est située en dessous de deux courbes limites définies réglementairement. Ces deux courbes comprennent, d'une part, une première courbe limite prédéterminée pour des fibrillations ventriculaires selon la norme IEC479 et, d'autre part, une seconde courbe limite prédéterminée associée à la protection contre le feu.

Voir aussi le document équivalent US 6 747 856 B1.

Le dispositif selon le document EP précité assure une telle protection contre le feu jusqu'à des fréquences de 20 kHz seulement. En effet, à partir de 10 kHz environ, des pertes supplémentaires surviennent dans le noyau (généralement un tore ferromagnétique) qui dégradent la tension au secondaire.

Or, il existe actuellement une demande pour disposer d'une protection contre le feu au-delà de 20 kHz et jusqu'à environ 100 kHz au moins.

Ainsi, le but premier de l'invention est de proposer un dispositif de protection différentielle du type évoqué en introduction et réalisant une fonction de protection contre le feu pour des fréquences élevées du courant de défaut, avantageusement situées au-delà de 20 kHz, ce tout en présentant une construction simple, de nature électromécanique (c'est-à-dire de type « voltage independent » : indépendant de la tension), peu coûteuse et d'encombrement réduit.

A cet effet, l'invention a pour objet un dispositif de protection différentielle présentant les caractéristiques de la revendication 1.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :
les figures 1 à 3 sont des représentations symboliques d'un dispositif de protection différentielle selon trois modes de réalisation de base de l'invention ;
les figures 4 à 6 sont des représentations schématiques de variantes plus perfectionnées de certains des modes de réalisation du dispositif représentés figures 1 à 3 ;
les figures 7 et 8 sont des représentations schématiques partielles d'un dispositif de protection différentielle selon d'autres variantes du mode de réalisation de l'invention représenté figures 4 et 6 ;
la figure 9 est une représentation schématique d'un arrangement possible de dispositifs différentiels selon l'invention, et

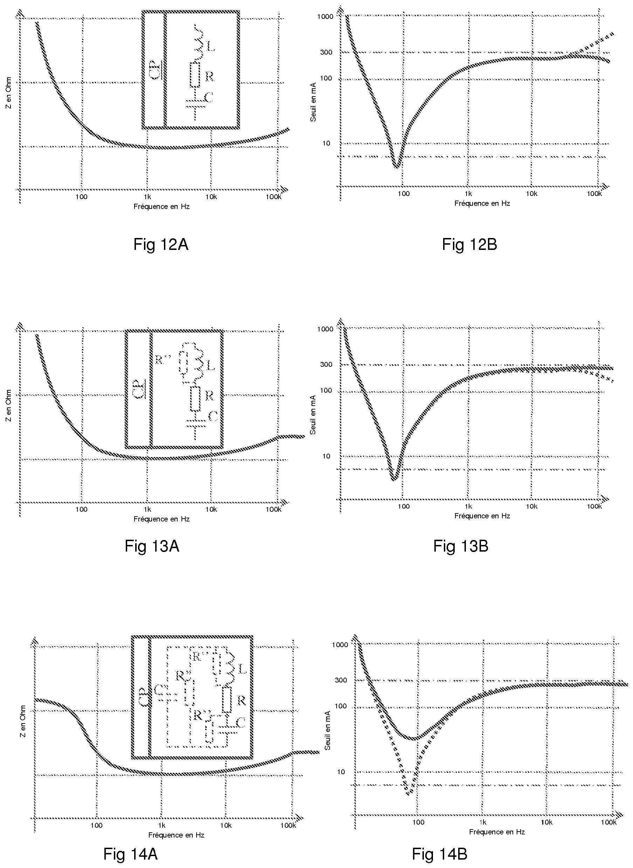

les figures 10 à 14 sont des courbes de sensibilité en termes de valeurs seuil de déclenchement de courant de fuite (figures B) et des courbes d'impédance équivalente (figures A) d'un circuit passif pouvant être mis en oeuvre respectivement dans chacune des constructions des dispositifs des figures 1 à 6 ce en fonction de la fréquence desdits courants, et à chaque fois pour la réalisation spécifique du circuit passif représenté schématiquement en insert de la figure A correspondante.

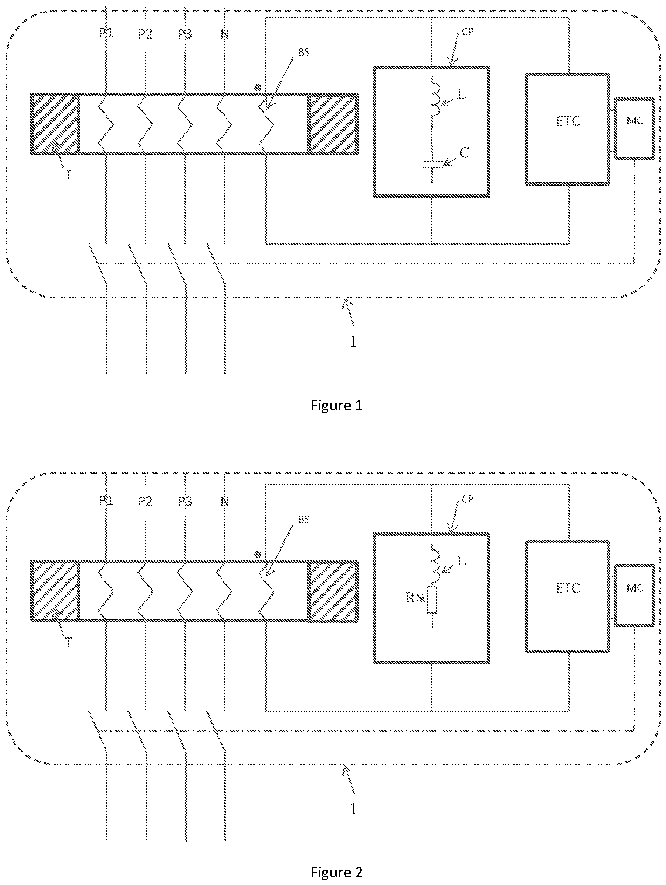

Les figures 1 à 6 montrent toutes un dispositif de protection différentielle 1 permettant la détection de courant de fuite ou de défaut dans une installation électrique alimentée par au moins un conducteur de phase P1, P2, P3 d'un réseau et au moins un conducteur de neutre et/ou de terre N dudit réseau.

Ce dispositif 1 comprend, d'une part, un transformateur avec un noyau, préférentiellement torique, en matériau ferromagnétique T, avec un primaire constitué par au moins deux des conducteurs P1, P2, P3, N précités et avec au moins un bobinage secondaire BS aux bornes duquel s'établit un signal induit lors de l'apparition d'un défaut différentiel au niveau du primaire, et d'autre part, au moins un circuit de traitement et de commande ETC adapté pour traiter le signal induit et pour, en cas de dépassement d'une valeur de seuil prédéfinie, commander un actionneur électromagnétique, un relais ou un moyen de coupure ou d'ouverture analogue MC du dispositif 1, le(s)dit(s) circuit(s) ETC étant relié(s) aux bornes du bobinage secondaire BS considéré.

Conformément à l'invention, il est prévu qu'un circuit passif CP comprenant une inductance L au moins, ainsi qu'au moins une résistance R et/ou au moins un condensateur C en série (avec l'inductance L), est relié aux bornes du bobinage secondaire BS, en parallèle sur ce dernier.

Grâce à la disposition technique ci-dessus, l'invention permet de fournir un dispositif 1 qui compense les capacités parasites et les pertes dans le tore T, qui permet de fournir un plateau pour des fréquences élevées, notamment supérieures à 100 kHz (l'inductance L compense les pertes du tore T) et qui permet de bien séparer le problème basse-fréquence et haute-fréquence.

Avantageusement, l'inductance L faisant partie du circuit passif CP est dimensionnée de telle manière que, pour des fréquences de courant de défaut supérieures à environ 20 kHz, le seuil de déclenchement du circuit ETC est inférieur ou égal à 420 mA, préférentiellement au plus égal à 300 mA.

Outre le fait d'étendre (par rapport à l'état de la technique) la sécurité normative pour la protection des personnes et la protection contre les incendies au-delà de 20kHz, préférentiellement au-delà de 100kHz, la mise en oeuvre d'une inductance L dimensionnée comme indiqué ci-dessus entraîne un renforcement de la sécurité (seuil de déclenchement plus bas) et permet simultanément de pouvoir corriger les défauts liés aux facteurs parasites de certains composants du dispositif 1, comme par exemple les capacités parasites des diodes transil DT, qui sont montées directement en parallèle de l'enroulement du bobinage secondaire BS.

Selon une première variante ou caractéristique de réalisation (figures 2 à 4 et 6), le circuit passif CP comprend également au moins une résistance R, montée en série avec l'inductance L. Le circuit CP peut alors être limité à un simple circuit LR série (figure 2).

Préférentiellement, la valeur de la résistance R est dimensionnée de telle manière que, pour des fréquences de courant de défaut supérieures à 20 kHz environ, le seuil de déclenchement du circuit ETC est inférieur ou égal à 420 mA, préférentiellement au plus égal à 300 mA.

Selon une seconde variante ou caractéristique de réalisation (figures 1, 3, 5 et 6), alternative ou cumulative avec la première variante précitée, le circuit passif CP comprend également au moins un condensateur C monté en série avec l'inductance L. Le circuit CP peut alors être limité à un simple circuit LC série (figure 1).

Préférentiellement, la capacité du condensateur C est dimensionnée de telle manière que, pour des fréquences de courant de défaut inférieures à environ 1 kHz, le seuil de déclenchement du circuit ETC est inférieur ou égal à 420 mA, préférentiellement au plus égal à 300 mA (ce condensateur C permet de régler le seuil de déclenchement à IDN pour une fréquence < 1000 Hz).

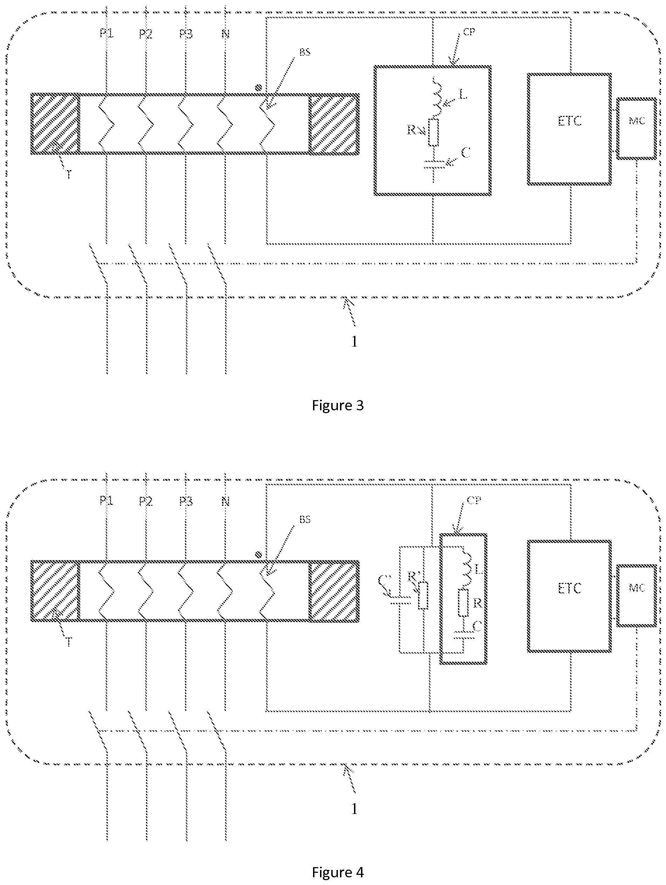

En accord avec un mode de réalisation extrêmement préféré de l'invention, et comme cela ressort des figures 3 et 6 à 8, le circuit passif CP comprend au moins un circuit RLC série (préférentiellement exactement un), les différents composants R, L et C dudit circuit étant dimensionnés de telle manière que le seuil de déclenchement du circuit ETC soit inférieur à 420 mA, préférentiellement inférieur ou égal à 300 mA, pour des fréquences du courant de défaut comprises entre 0 Hz et 50 kHz au moins, préférentiellement entre 0 Hz et 100 kHz au moins.

Les composants R, L et C constitutifs du circuit passif peuvent être associés ou non à des composants passifs additionnels comme évoqué ci-après.

Grâce aux configurations et aux dimensionnements des composants R, L et C mentionnés dans les variantes et modes de réalisations précités, l'invention permet de respecter simultanément les contraintes de limite de courant fixées par le standard IEC479-2 (risques de fibrillation cardiaque), ainsi que les contraintes de limite de courant stipulées dans le standard IEC60364-4-42 et les directives 3501 VDS (risques d'emballement thermique).

Pour les constructions représentées sur les figures, les valeurs des composants du circuit RLC peuvent être choisis comme suit : R compris entre 2000 ohms et 7000 ohms ; L compris entre 1 mH et 10 mH ; C compris entre 20 nf et 80 nf.

Comme le montrent les figures 4 à 8, il peut être prévu qu'une résistance R' soit montée en parallèle sur le circuit passif CP, en étant reliée aux bornes opposées de ce dernier. Une telle résistance supplémentaire R' (par exemple comprise entre 0,1 Mohms et 1,0 Mohms) permet de fixer l'impédance aux basses fréquences et la réalisation de dispositifs 1 avec des sensibilités différentes (100 mA, 300 mA, 420 mA, ...) tout en utilisant le même tore T (diminution du courant débité par le tore T et réglage des temps de déclenchement de l'étage ETC).

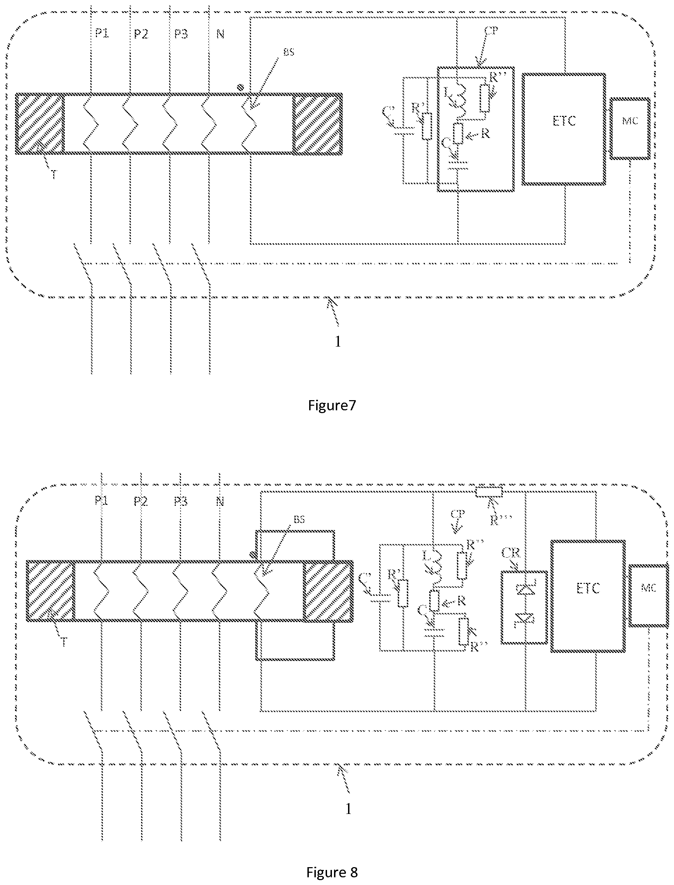

Alternativement ou simultanément, il peut aussi être prévu qu'une résistance R" soit montée en parallèle aux bornes de l'inductance L ou du condensateur C faisant partie du circuit passif CP (figure 8). Une telle résistance additionnelle R" (par exemple compris entre 10 kohms et 1 Mohms) permet de fixer un palier supplémentaire limitant selon le cas l'influence de l'inductance L ou du condensateur C et de fixer un autre seuil de déclenchement pour des fréquences élevées, notamment supérieures à 100 Khz pour L et en basse fréquence pour C.

Selon une autre caractéristique possible de l'invention, un condensateur C' peut être monté en parallèle sur le circuit passif CP, en étant relié aux bornes opposées de ce dernier. Ce condensateur C' (par exemple de quelques pF) peut réaliser un filtrage des fréquences au-delà d'une certaine valeur, par exemple au-delà d'environ 100 kHz (figures 4 à 8).

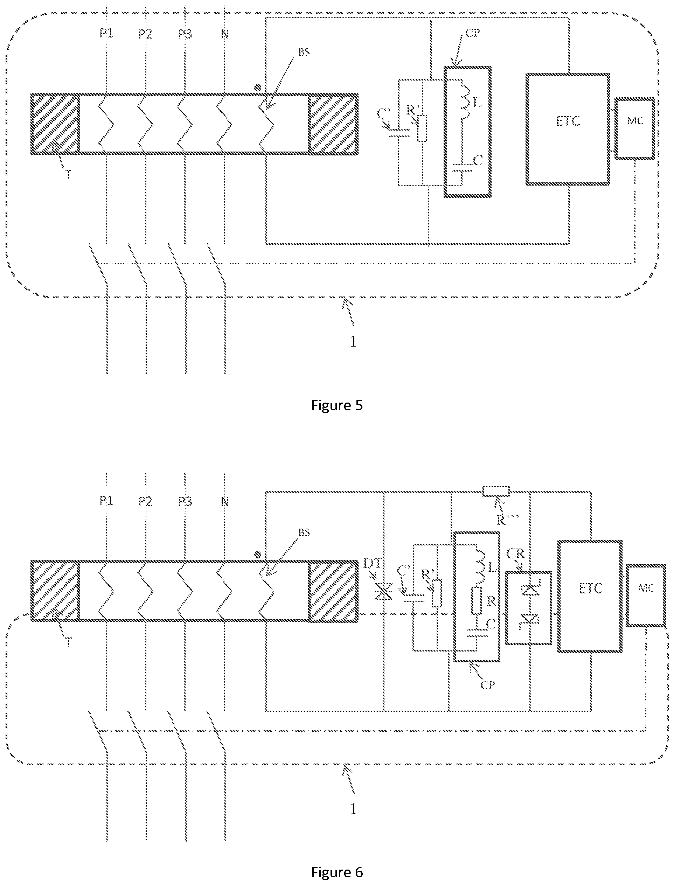

Conformément à une autre caractéristique additionnelle possible de l'invention, ressortant plus particulièrement des figures 7 et 8, il peut être prévu qu'une résistance R‴ soit montée en série sur l'une des entrées du circuit de traitement et de commande ETC, en aval du circuit passif CP par rapport au bobinage secondaire BS (figures 6 et 8).

La résistance R‴ (éventuellement intégrée à l'ETC) crée une chute de tension et permet de limiter la surtension en cas de coup de foudre.

Afin d'éviter les déclenchements intempestifs du dispositif 1 lors de courants élevés du type foudre et surtout de protéger les composants électroniques du circuit ETC, le dispositif 1 peut comprendre, en outre, une diode transil DT qui est montée en parallèle sur le circuit de traitement et de commande ETC ou sur le circuit passif CP et reliée aux bornes du bobinage secondaire BS.

Enfin, comme le montre la figure 6, un circuit écrêteur de tension CR, par exemple à diodes Zener, peut être monté en parallèle sur les entrées du circuit de commande et de traitement ETC.

L'invention a également pour objet un dispositif différentiel de type F ou de type B, caractérisé en ce qu'il intègre un dispositif 1 tel que décrit ci-dessus.

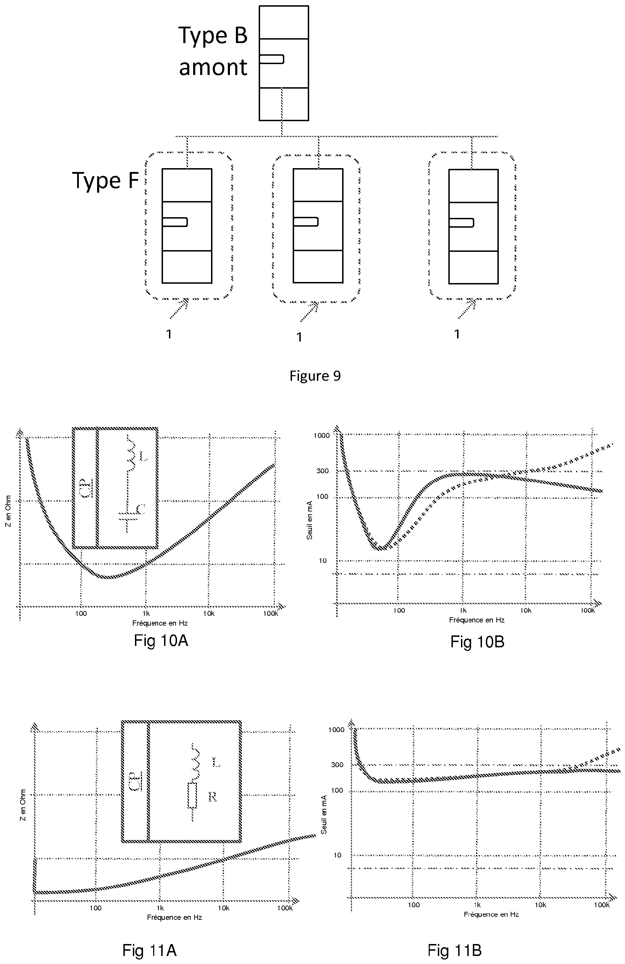

Enfin, l'invention concerne également, comme le montre la figure 11, un arrangement de dispositifs différentiels à deux niveaux, comprenant un dispositif différentiel de type B, de nature électromécanique et électronique, en amont et plusieurs dispositifs différentiels de type F, de nature exclusivement électromécanique, en aval, cet arrangement étant caractérisé en ce que les dispositifs de type F correspondent chacun à un dispositif 1 tel que mentionné ci-dessus (les dispositifs de type F visés dans la présente sont compatibles avec le dispositif amont de type B, et acceptent la valeur de courant continu de ce dernier, les deux fonctions étant indépendantes).

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention, tel que défini dans les revendications annexées.

## Revendications

1. Dispositif (1) de protection différentielle permettant la détection de courant de fuite ou de défaut dans une installation électrique alimentée par au moins un conducteur de phase (P1, P2, P3) d'un réseau et au moins un conducteur de neutre et/ou de terre (N) dudit réseau,
ledit dispositif (1) comprenant, d'une part, un transformateur avec un noyau, préférentiellement torique, en matériau ferromagnétique (T), avec un primaire constitué par au moins deux des conducteurs (P1, P2, P3, N) précités et avec au moins un bobinage secondaire (BS) aux bornes duquel s'établit un signal induit lors de l'apparition d'un défaut différentiel au niveau du primaire et, d'autre part, au moins un circuit de traitement et de commande (ETC) adapté pour traiter le signal induit et pour, en cas de dépassement d'une valeur de seuil prédéfinie, commander un actionneur électromagnétique, un relais ou un moyen de coupure ou d'ouverture analogue (MC) du dispositif (1), le(s)dit(s) circuit(s) de traitement et de commande (ETC) étant relié(s) aux bornes du bobinage secondaire (BS) considéré,
dispositif de protection différentielle (1) **caractérisé**
**en ce qu'**un circuit passif (CP) comprenant une inductance (L) au moins, ainsi qu'au moins une résistance (R) et/ou au moins un condensateur (C) monté(e)(s) en série avec ladite au moins une inductance (L), est relié aux bornes du bobinage secondaire (BS), en parallèle sur ce dernier,
l'inductance (L) faisant partie du circuit passif (CP) étant dimensionnée de telle manière que, pour des fréquences de courant de défaut supérieures à environ 20 kHz, le seuil de déclenchement du circuit (ETC) est inférieur ou égal à 420 mA.

2. Dispositif de protection différentielle selon la revendication 1, **caractérisé en ce que** le circuit passif (CP) comprend au moins un circuit RLC série, les différents composants (R, L et C) dudit circuit étant dimensionnés de telle manière que le seuil de déclenchement du circuit (ETC) est inférieur à 420 mA, pour des fréquences du courant de défaut comprises entre 0 Hz et 50 kHz au moins, préférentiellement comprises entre 0 Hz et 100 kHz.

3. Dispositif de protection différentielle selon l'une quelconque des revendications 1 et 2, **caractérisé en ce que** le seuil de déclenchement du circuit (ETC) est inférieur ou égal à 300 mA.

4. Dispositif de protection différentielle selon l'une quelconque des revendications 1 à 3, **caractérisé en ce qu'**une résistance (R') est montée en parallèle sur le circuit passif (CP), en étant reliée aux bornes opposées de ce dernier.

5. Dispositif de protection différentielle selon l'une quelconque des revendications 1 à 4, **caractérisé en ce qu'**une résistance (R") est montée en parallèle aux bornes de l'inductance (L) ou du condensateur (C) faisant partie du circuit passif (CP).

6. Dispositif de protection différentielle selon l'une quelconque des revendications 1 à 5, **caractérisé en ce qu'**un condensateur (C') est monté en parallèle sur le circuit passif (CP), en étant relié aux bornes opposées de ce dernier.

7. Dispositif de protection différentielle selon l'une quelconque des revendications 1 à 6, **caractérisé en ce qu'**une résistance (R‴) est montée en série sur l'une des entrées du circuit de traitement et de commande (ETC), en aval du circuit passif (CP) par rapport au bobinage secondaire (BS).

8. Dispositif de protection différentielle selon l'une quelconque des revendications 1 à 7 **caractérisé en ce qu'**il comprend, en outre, une diode transil (DT) qui est montée en parallèle sur le circuit de traitement et de commande (ETC) ou sur le circuit passif (CP), et reliée aux bornes du bobinage secondaire (BS).

9. Dispositif différentiel de type F ou de type B, **caractérisé en ce qu'**il intègre un dispositif selon l'une quelconque des revendications 1 à 8.

10. Arrangement de dispositifs différentiels à deux niveaux, comprenant un dispositif différentiel de type B, de nature électromécanique et électronique, en amont et plusieurs dispositifs différentiels de type F, de nature exclusivement électromécanique, en aval, arrangement **caractérisé en ce que** les dispositifs de type F correspondent chacun à un dispositif selon l'une quelconque des revendications 1 à 8.

## Patentansprüche

1. Differenzialschutzvorrichtung (1), die die Detektion eines Leck- oder Fehlerstroms in einer elektrischen Anlage ermöglicht, die von mindestens einem Phasenleiter (P1, P2, P3) eines Netzes und mindestens einem Neutral- und/oder Erdungsleiter (N) des Netzes versorgt wird,
wobei die Vorrichtung (1) einerseits einen Transformator mit einem vorzugsweise torischen Kern aus ferromagnetischem Material (T), mit einer Primärwicklung, die aus mindestens zwei der genannten Leiter (P1, P2, P3, N) besteht, und mindestens einer Sekundärwicklung (BS), an deren Anschlüssen sich bei Auftreten eines Differenzfehlers in der Primärwicklung ein induziertes Signal aufbaut, und andererseits mindestens eine Verarbeitungs- und Steuerschaltung (ETC) umfasst, die dazu geeignet ist, das induzierte Signal zu verarbeiten und im Falle einer Überschreitung eines vordefinierten Schwellenwertes ein elektromagnetisches Stellglied, ein Relais oder ein analoges Ausschalt- oder Öffnungsmittel (MC) der Vorrichtung (1) zu steuern, wobei der/die Verarbeitungs- und Steuerschaltung(en) (ETC) mit den Anschlüssen der Sekundärwicklung (BS) verbunden ist/sind,
Differenzialschutzvorrichtung (1), **dadurch gekennzeichnet, dass** eine passive Schaltung (CP), die mindestens einen Induktor (L) sowie mindestens einen Widerstand (R) und/oder mindestens einen Kondensator (C) enthält, die mit dem mindestens einen Induktor (L) in Reihe geschaltet sind, mit den Anschlüssen der Sekundärwicklung (BS) verbunden ist, mit letzterer parallel,
wobei der Induktor (L) Teil der passiven Schaltung (CP) so bemessen ist, dass bei Fehlerstromfrequenzen von ca. 20 kHz die Auslöseschwelle der Schaltung (ETC) kleiner oder gleich 420 mA ist.

2. Differenzialschutzvorrichtung nach Anspruch 1, **dadurch gekennzeichnet, dass** die passive Schaltung (CP) mindestens eine RLC-Reihenschaltung umfasst, wobei die verschiedenen Komponenten (R, L und C) der Schaltung so bemessen sind, dass die Auslöseschelle der Schaltung (ETC) bei Fehlerstromfrequenzen zwischen 0 Hz und mindestens 50 kHz, vorzugsweise zwischen 0 Hz und 100 kHz, kleiner als 420 mA ist.

3. Differenzialschutzvorrichtung nach einem der Ansprüche 1 und 2, **dadurch gekennzeichnet, dass** die Auslöseschwelle der Schaltung (ETC) kleiner oder gleich 300 mA ist.

4. Differenzialschutzvorrichtung nach einem der Ansprüche 1 bis 3, **dadurch gekennzeichnet, dass** ein Widerstand (R') parallel zur passiven Schaltung (CP) geschaltet ist, indem er mit entgegengesetzten Anschlüssen der Letzteren verbunden ist.

5. Differenzialschutzvorrichtung nach einem der Ansprüche 1 bis 4, **dadurch gekennzeichnet, dass** ein Widerstand (R") parallel zu den Anschlüssen des Induktors (L) oder des Kondensators (C) geschaltet ist, die Teil der passiven Schaltung (CP) sind.

6. Differenzialschutzvorrichtung nach einem der Ansprüche 1 bis 5, **dadurch gekennzeichnet, dass** ein Kondensator (C') parallel zur passiven Schaltung (CP) geschaltet ist, indem er mit entgegengesetzten Anschlüssen der Letzteren verbunden ist.

7. Differenzialschutzvorrichtung nach einem der Ansprüche 1 bis 6, **dadurch gekennzeichnet, dass** ein Widerstand (R‴) in Reihe an einen der Eingänge der Verarbeitungs- und Steuerschaltung (ETC) geschaltet ist, der passiven Schaltung (CP) in Bezug auf die Sekundärwicklung (BS) nachgeschaltet.

8. Differenzialschutzvorrichtung nach einem der Ansprüche 1 bis 7, **dadurch gekennzeichnet, dass** sie außerdem eine Transil-Diode (DT) umfasst, die parallel zur Verarbeitungs- und Steuerschaltung (ETC) oder zur passiven Schaltung (CP) geschaltet ist und mit den Anschlüssen der Sekundärwicklung (BS) verbunden ist.

9. Differenzialvorrichtung vom Typ F oder vom Typ B, **dadurch gekennzeichnet, dass** sie eine Vorrichtung nach einem der Ansprüche 1 bis 8 integriert.

10. Zweistufige Anordnung von Differenzialvorrichtungen, die eine vorgeschaltete Differenzialvorrichtung vom Typ B elektromechanischer oder elektronischer Art und mehrere nachgeschaltete Differenzialvorrichtungen vom Typ F ausschließlich elektromechanischer Art umfasst, wobei die Anordnung **dadurch gekennzeichnet ist, dass** die Vorrichtungen vom Typ F jeweils einer Vorrichtung nach einem der Ansprüche 1 bis 8 entsprechen.

## Claims

1. Differential protection device (1) for detecting leakage current or fault current in an electrical installation powered by at least one phase conductor (P1, P2, P3) of a network and at least one neutral and/or earth conductor (N) of said network,
said device (1) comprising, on the one hand, a transformer with a preferentially toroidal core made of ferromagnetic material (T), with a primary winding composed of at least two of the aforementioned conductors (P1, P2, P3, N) and with at least one secondary winding (BS) across the terminals of which is established a signal induced when a differential fault occurs at the primary winding and, on the other hand, at least one processing and control circuit (ETC) designed to process the induced signal and, in the event that a predefined threshold value is exceeded, to control an electromagnetic actuator, a relay or an analogue means (MC) for disconnecting or opening the device (1), said processing and control circuit(s) (ETC) being connected to the terminals of the secondary winding (BS) in question,
the differential protection device (1) being **characterized in that** a passive circuit (CP) comprising one inductor (L) at least, and at least one resistor (R) and/or at least one capacitor (C) connected in series with said at least one inductor (L), is connected to the terminals of the secondary winding (BS), in parallel with the latter,
the inductor (L) that forms part of the passive circuit (CP) being dimensioned in such a way that, for fault current frequencies greater than approximately 20 kHz, the triggering threshold of the circuit (ETC) is less than or equal to 420 mA.

2. Differential protection device according to Claim 1, **characterized in that** the passive circuit (CP) comprises at least one series RLC circuit, the various components (R, L and C) of said circuit being dimensioned in such a way that the triggering threshold of the circuit (ETC) is less than 420 mA, for fault current frequencies between 0 Hz and 50 kHz at least, preferentially between 0 Hz and 100 kHz.

3. Differential protection device according to either of Claims 1 and 2, **characterized in that** the triggering threshold of the circuit (ETC) is less than or equal to 300 mA.

4. Differential protection device according to any one of Claims 1 to 3, **characterized in that** a resistor (R') is connected in parallel with the passive circuit (CP) by being connected to the opposite terminals of the latter.

5. Differential protection device according to any one of Claims 1 to 4, **characterized in that** a resistor (R") is connected in parallel across the terminals of the inductor (L) or of the capacitor (C) that forms part of the passive circuit (CP).

6. Differential protection device according to any one of Claims 1 to 5, **characterized in that** a capacitor (C') is connected in parallel with the passive circuit (CP) by being connected to the opposite terminals of the latter.

7. Differential protection device according to any one of Claims 1 to 6, **characterized in that** a resistor (R‴) is connected in series with one of the inputs of the processing and control circuit (ETC), downstream of the passive circuit (CP) with respect to the secondary winding (BS).

8. Differential protection device according to any one of Claims 1 to 7, **characterized in that** it further comprises a transil diode (DT) which is connected in parallel with the processing and control circuit (ETC) or with the passive circuit (CP), and connected to the terminals of the secondary winding (BS).

9. F-type or B-type differential device, **characterized in that** it incorporates a device according to any one of Claims 1 to 8.

10. Two-tier arrangement of differential devices, comprising a B-type differential device, of electromechanical and electronic nature, upstream and a plurality of F-type differential devices, exclusively of electromechanical nature, downstream, the arrangement being **characterized in that** the F-type devices each correspond to a device according to any one of Claims 1 to 8.
